# DEMANDE DE BREVET EUROPEEN

(11) **EP 2 669 852 A1**
(43) Date de publication de la demande: **04.12.2013**
(21) Numéro de dépôt: 12305604.6
(22) Date de dépôt: 31.05.2012
(51) Int. Cl.: G06K 19/077

(54) **Module à puce de circuit intégré avec antenne**

(71) Demandeur: Gemalto SA, 92190 Meudon (FR)
(72) Inventeur: Buyukkalender, Arek, 13013 Marseille (FR); Seban, Frédérick, 13260 Cassis (FR); Audouard, Laurent, 13400 Aubagne (FR); Bousquet, Christophe, 83500 La Seyne sur Mer (FR)

(57) **Abrégé**

L'invention concerne un module à puce de circuit intégré (1C) comprenant un substrat isolant (3), une antenne (2) comportant plusieurs spires (2s) et deux extrémités de connexion (8, 9) réalisées sur un même côté (12) du substrat,
- une zone d'enrobage ou d'emplacement de la puce de circuit intégré, ladite zone d'enrobage étant localisée sensiblement au centre du substrat,
- un parcours des spires situé sensiblement en zone périphérique (C) du module ;

Le module comprend une déviation (D) du parcours des spires, ladite déviation allant de la zone périphérique (C) vers ladite zone d'enrobage de manière à ce que l'extrémité de connexion (8) de la spire externe parvienne dans ladite zone.

## Description

### Domaine de l'invention.

L'invention concerne un module électronique comprenant une puce de circuit intégré connectée à une antenne radiofréquence ;

L'invention peut concerner notamment le domaine des supports électroniques tels que cartes à puce à contacts et/ou sans contact ou cartes hybrides, tickets ou étiquettes radiofréquences, transpondeurs radiofréquences, inserts (ou inlay) intégrant ou constituant un tel module.
De tels supports électroniques peuvent être conformes notamment au standard ISO / IEC 14443 ou ISO 78016.

Dans une application préférée, le module de l'invention est associé à une antenne passive ou relais pour une augmentation de la portée de la communication radiofréquence. L'antenne passive et/ou le module peuvent être placés de préférence dans un corps de carte à puce ou tout autre dispositif, par exemple un téléphone sous forme amovible ou soudée.

### Art antérieur.

Il est connu de fabriquer un module de carte à puce par les étapes correspondant au préambule de la revendication 1. De tels modules sont décrits dans le brevet FR 2743649 B1. Selon les variantes exposées, la puce peut être placée à cheval sur les spires d'une antenne et en périphérie de manière à permettre une connexion à la puce par fil soudé.

Dans une autre variante, la puce est placée au centre du module, l'antenne comporte une extrémité de connexion située en périphérie des spires et on réalise la connexion de la puce à cette extrémité par fil soudé enjambant les spires.

Dans une autre variante, le module comporte un pont conducteur réalisé sur la face opposée à celle portant les spires et des vias conducteurs traversent le support pour relier le pont conducteur à l'antenne.

Ces réalisations ne permettent pas un collage amélioré du module dans un corps de carte, le collage s'effectuant sur la périphérie.

La demande de brevet EP0737935 A2 décrit une feuille de corps de carte sans contact supportant une antenne. La puce est disposée avec la face active tournée vers les connexions de l'antenne et en étant à cheval au-dessus du parcours périphérique des spires. Les spires ont un espacement inter-spires réduit entre les plots de connexion de la puce.

### Problème technique.

Le but de l'invention est de réduire les coûts ou étapes de fabrication ; Dans un mode préféré, le module permet également un collage dans une cavité de corps de carte.

Un autre objectif est d'améliorer la fiabilité des modules, en limitant la longueur des fils de soudure connectant la puce aux pistes et permettant de contenir les fils au centre du module pour les protéger par un enrobage de protection.

### Résumé de l'invention.

L'invention consiste à réaliser toute l'antenne avec ses extrémités sur une même face du film diélectrique du module puis à faire en sorte, par un motif d'antenne, que l'extrémité de connexion de la spire externe de l'antenne se termine dans une zone d'enrobage de la puce ou une zone située à proximité d'un emplacement de la puce localisée sensiblement au centre du module.

Ainsi, on peut protéger les fils de connexion de la puce à l'antenne dans la zone centrale d'enrobage tout en ayant l'antenne sur une seule face.
On simplifie également la fabrication avec une gravure simple face tout en ayant une position centrale de la puce permettant le cas échéant une surface optimale de collage.

L'invention a donc pour objet un module à puce de circuit intégré, comprenant un substrat isolant et une antenne comportant plusieurs spires et deux extrémités de connexion réalisées d'un même côté du substrat,
- une zone d'enrobage ou d'emplacement de la puce de circuit intégré, ladite zone étant localisée sensiblement au centre du substrat,
- un parcours des spires situé sensiblement en zone périphérique du module ;
Le module se distingue en ce qu'il comprend une déviation (D) du parcours de spires externes, ladite déviation allant de la zone périphérique vers ladite zone d'enrobage ou d'emplacement de la puce de manière à ce que l'extrémité de connexion de la spire externe parvienne dans ladite zone d'enrobage où dans une zone située à proximité de l'emplacement de la puce et sensiblement au centre du module.

L'enrobage étant concentré dans la zone centrale, le module peut être collé dans une cavité de corps de carte par sa zone périphérique puisque contrairement à l'art antérieur cette zone est exempte de puce ou d'enrobage.

D'autres caractéristiques et mode de mise en oeuvre font l'objet des revendications 2 et 3.

Brève description des figures.
- Les figures 1-2 illustrent des modules de carte à puce de l'art antérieur ;
- La figure 3 est une vue de dessus d'un module conforme à l'invention ;
- La figure 4 est une vue en coupe partielle de la figure 3.

### Description.

Dans les dessins, les mêmes références indiquent des éléments identiques ou similaires.

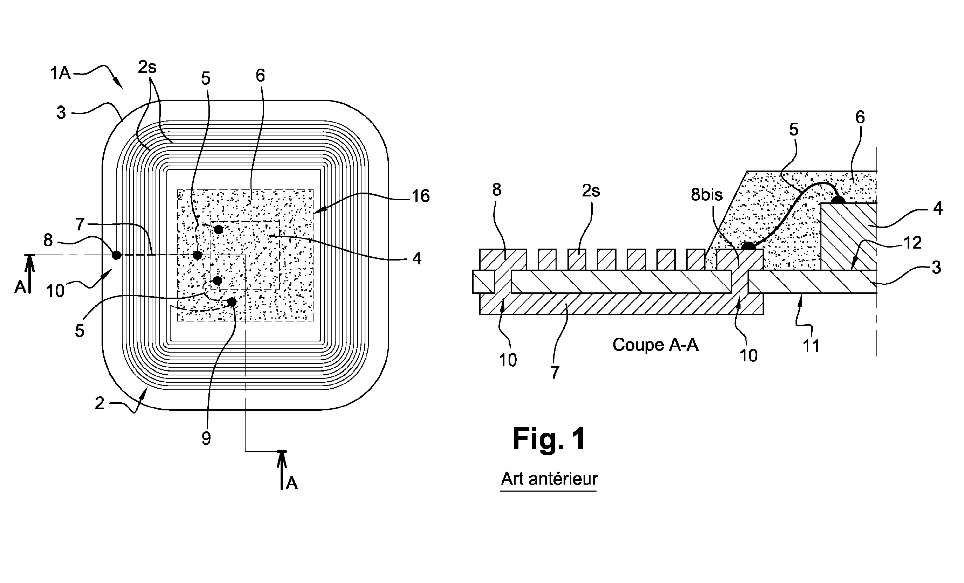

La figure 1 illustre un module 1 de carte à puce de circuit intégré de l'art antérieur en vue de dessus et en coupe A-A. Il comprend une antenne 2 sur un support diélectrique ou isolant 3 notamment du type LFCC (Lead frame contrecollé) ou de type gravée, au moins une puce de circuit intégré 4 reportée sur le support.
Le module comprend également des connexions 5 pour connecter des plots de la puce par fils soudés, un enrobage 6 de la puce et/ou de ses connexions par une matière de protection telle une résine (glob-top), qui peut être déposée par exemple sous forme de goutte ou par surmoulage.

Un pont conducteur 7 est réalisé sur la face opposée 11 à celle 12 portant les spires pour ramener l'extrémité externe 8 de l'antenne vers l'intérieur des spires en une plage 8bis en passant sur ladite face opposée. Des vias conducteurs 10 traversent le support pour relier le pont à l'extrémité de connexion de l'antenne 8 et à une plage 8bis de connexion à la puce.

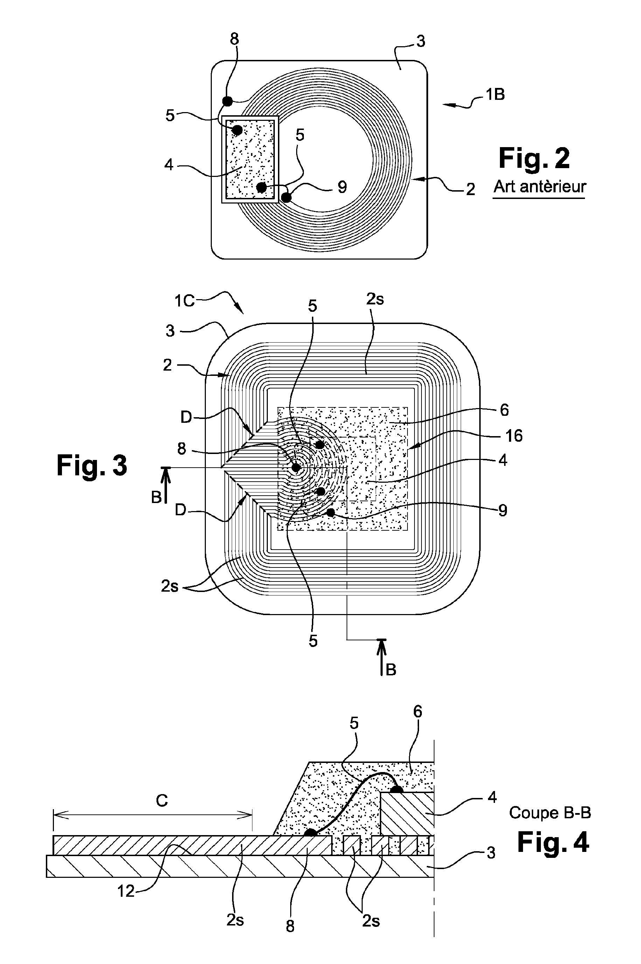

Sur la figure 2, un autre module 1B de l'art antérieur, cité en introduction, comprend une puce 4 placée à cheval sur les spires d'antenne et en périphérie du module.

A la figure 3, un module à puce de circuit intégré 1C selon un mode de réalisation conforme à l'invention comprend un substrat isolant 3, une antenne 2 réalisée ici par gravure qui comporte plusieurs spires 2s et deux extrémités de connexion 8, 9 réalisées d'un même côté du substrat 3 ; Ici elle est réalisée complètement dans un même plan sur une même face 12 du support isolant ;
- Sur le module est définie une zone d'enrobage 16 de la puce de circuit intégré localisée sensiblement au centre du substrat 3 ; En cas de défaut d'enrobage du fait notamment d'un report de la puce en configuration retournée (flip-chip), la zone correspond à une zone adjacente à la zone périphérique de collage du module ou dans le cas d'une utilisation qui ne requiert pas de collage dans un corps de carte, à un emplacement sensiblement centré de la puce de circuit intégré ;
- Les spires 2s suivent un parcours situé sensiblement en zone périphérique du module ; Leur nombre peut varier par exemple de 3 à 15 spires environ.

Selon une caractéristique de ce mode de réalisation, le module comprend une déviation D du parcours périphérique de spires externes en direction de la zone d'enrobage 16 ou à proximité de la puce (par exemple de 0.5 à 5 mm de la puce). Cette déviation peut s'effectuer sensiblement à environ 45° par rapport au parcours périphérique en direction de la puce tout en contournant l'extrémité externe de l'antenne qui est ramenée à proximité de la puce.

L'extrémité de connexion est ici un point 8 qui est contourné par les spires en formant ici des cercles autour de cette extrémité de connexion. Le contournement peut s'effectuer par d'autres formes par exemple un carré, rectangle, etc.

La déviation de parcours s'étend de la zone périphérique vers la zone d'enrobage ou emplacement la puce de manière à ce que l'extrémité de connexion de la spire externe parvienne dans la zone d'enrobage ou zone adjacente située à proximité immédiate de la puce.

La déviation contourne une portion de spire externe qui rapproche l'extrémité de connexion de la spire externe au plus près de la puce jusque dans la zone d'enrobage ou à proximité de la puce ou sous la puce (cas de puce retournée).

Dans le mode de réalisation préféré, la zone périphérique correspond à une surface de collage du module dans une cavité de corps de carte ; cette zone est représentée avec une largeur C.

Avantageusement, l'extrémité de la spire externe est rapprochée de la puce sans avoir de pont conducteur qui enjambe les spires du côté d'une même face ou qui passe sur la face opposée à celle portant les spires. Dans ce dernier cas, le module ne comporte pas non plus de vias conducteurs traversant le substrat et reliant les spires au pont conducteur.

Dans l'exemple, le module comprend ou est destiné à comprendre une puce de circuit intégré reportée sensiblement au centre du module dans une zone d'enrobage ; Elle est connectée aux extrémités de l'antenne par des connexions en fil soudé 5.

Alternativement, la connexion peut s'effectuer par d'autres moyens connus de l'homme de l'art, notamment colle conductrice ; La puce peut être reportée et connectée en version puce retournée (flip-chip).

Une matière de protection 6 est déposée dans la zone d'enrobage 16 pour enrober au moins partiellement la puce et ses connexions.

Dans le cas du mode de réalisation avec puce retournée, l'enrobage peut être évité ou être partiel.

Ainsi conçu, le module a l'avantage d'avoir l'antenne entièrement sur une face, d'être économique et le cas échéant de permettre un bon collage du module sur sa périphérie dans une cavité de corps de carte.

Ainsi, le module de type sans contact à antenne radiofréquence peut être associé à un dispositif tel qu'une carte à puce ou tout autre objet communiquant.

Dans un mode particulier de réalisation, pour augmenter la portée de communication sans contact, l'antenne du module est de préférence couplée électro-magnétiquement à une antenne passive.

L'antenne passive peut être disposée dans un corps de carte ou passeport ou un lecteur radiofréquence. Le cas échéant, l'antenne est disposée dans ou sur un téléphone portable ou assistant personnel électronique notamment dans le boîtier. L'antenne passive peut être réalisée par exemple en fil incrusté, par gravure, selon une technologie d'étiquette électronique etc.

Quel que soit le mode de réalisation, on peut prévoir des formes et/ou connexions, plages de contact, plages de soudure ou de connexion de manière à ce que le module soit adapté pour être amovible ou soudé sur un dispositif électronique quelconque tel un téléphone mobile, un ordinateur personnel (PDA). Même sur un corps de carte, le module peut être adapté pour être détachable avec notamment un adhésif repositionnable placé sur la surface de collage C (fig. 1A).

Le module peut par exemple être surmoulé complètement notamment pour recouvrir toute la surface du support du côté de la puce et laissé des plages de contact ou connexion à souder sur l'autre face opposée ou sur un côté quelconque du module.

## Revendications

1. Module à puce de circuit intégré (1C), comprenant :
- un substrat isolant (3),
- une antenne (2) comportant plusieurs spires (2s) et deux extrémités de connexion (8, 9) réalisées d'un même côté du substrat (12),
- une zone d'enrobage ou d'emplacement de la puce de circuit intégré, ladite zone étant localisée sensiblement au centre du substrat,
- un parcours des spires situé sensiblement en zone périphérique (C) du module,
**caractérisé en ce qu'**il comprend une déviation (D) du parcours des spires, ladite déviation allant de la zone périphérique (C) vers ladite zone de manière à ce que l'extrémité de connexion (8) de la spire externe parvienne dans ladite zone.

2. Module selon la revendication précédente, **caractérisé en ce qu'**il comprend une puce (4) connectée aux extrémités 8, 9 de l'antenne (2) par des connexions en fil soudé (5), une matière de protection (6) dans ladite zone d'enrobage enrobant au moins partiellement la puce et ses connexions.

3. Module selon l'une des revendications précédentes, **caractérisé en ce qu'**il est adapté pour être amovible ou soudé.

4. Dispositif tel qu'une carte à puce comportant le module selon l'une des revendications précédente et une antenne passive couplée électro-magnétiquement avec l'antenne du module.
